(19)

Europäisches
Patentamt
European
Patent Office
Office européen
des brevets

(11) **EP 2 357 483 B1**

(12) **EUROPEAN PATENT SPECIFICATION**

(45) Date of publication and mention
of the grant of the patent:
**26.06.2013 Bulletin 2013/26**

(51) Int Cl.:
***G01R 23/02*** *(2006.01)*       ***G01R 19/25*** *(2006.01)*
***H02H 3/46*** *(2006.01)*

(21) Application number: **10460004.4**

(22) Date of filing: **17.02.2010**

(54) **A method of subsynchronous resonance detection**

Verfahren zur Detektion von subsynchroner Resonanz

Procédé de détection à résonance hyposynchrone

(84) Designated Contracting States:
**AT BE BG CH CY CZ DE DK EE ES FI FR GB GR
HR HU IE IS IT LI LT LU LV MC MK MT NL NO PL
PT RO SE SI SK SM TR**

(43) Date of publication of application:
**17.08.2011 Bulletin 2011/33**

(73) Proprietor: **ABB Research Ltd.**
**8050 Zürich (CH)**

(72) Inventors:
• **Orman, Maciej**
  **Radziszów 32-052 (PL)**

• **Balcerek, Przemyslaw**
  **30-389 Krakow (PL)**
• **Orkisz, Michal**
  **30-076 Krakow (PL)**

(74) Representative: **Chochorowska-Winiarska,**
**Krystyna**
**ABB Sp. z o. o.,**
**Ul. Zeganska 1**
**04-713 Warszawa (PL)**

(56) References cited:
**US-A- 4 125 884     US-A- 4 292 545**
**US-A- 4 607 217     US-A1- 2003 160 600**

**Description**

The subject of the invention is a method of subsynchronous resonance detection in electrical power systems with series capacitors.

In general, the subsynchronous resonance phenomenon SSR (SubSynchronous Resonance) occurs in electrical power systems as a result of the interaction of a turbine-generator with a long-distance series compensated transmission line. There is a condition of an electrical power system where electrical networks exchange energy with the mechanical system of the generator at frequencies less than the nominal frequency of the transmission line (50 or 60 Hz).

Subsynchronous resonance is addressed in three categories, the induction generator effect, torsional interaction and torque amplification. The first two types are caused by a steady state disturbance, while the third is excited by transient disturbances.

Series capacitors enhance the capabilities of power electrical systems by compensating transmission line inductance thus increasing the capacity of lines and thereby improving steady state and transient stability limits. However, the use of series capacitors increase the risk of occurrence of the subsynchronous resonance phenomenon. Typically, the frequency of subsynchronous resonance has a value in the range 15 % - 90 % of the nominal frequency of the transmission line.

The known methods of detecting subsynchronous resonance SSR are based on filtering techniques or an analysis of generator shaft vibration. Document US 2003/0160600 A describes a sub-synchronous current detection method which uses a signal rectification and a threshold comparison for detecting sub-synchronous currents. The method can be implemented either as an analogue circuit or also by using digital signal processing circuitry. Another method is known from US patent 4.607.217. Subsynchronous resonance is detected in an AC electrical power supply system by determining changes in the length of successive wave-form half cycles which are the basis for identifying subsynchronous resonance. The parameter change measured is the wave period, and changes in the ratio of the difference of the period of positive and period of negative half cycles over the sum of the period positive and the period of negative half cycles are related to the detection of subsynchronous resonance. The invention is based on the observation that subsynchronous frequency in the current line creates a longer half cycle and shorter half cycles. The difference between the half cycle periods is measured successively to provide a method of detecting the presence of subsynchronous resonance.

A disadvantage of this method is the presence of a time delay between the appearance of the subsynchronous resonance phenomenon and its detection. This time delay may be too long for SSR frequency detection, which may result in damage to the shaft or maloperation of the transmission line protection relay. This disadvantage is overcome by the invented method as defined in claim 1, which allows SSR detection and identification faster in comparison to known techniques and requires the use of small sample amount of input data than in known solutions.

The essence of the inventive method of subsynchronous resonance detection in electrical power systems with series capacitors, in which voltage signals are measured on line and by using a method of finding zero crossing points of discrete signal of measured voltage, positive and negative half cycles of a wave form of discrete signal of voltage are calculated in a computer device to which constant parameters are delivered by the user, is that it includes the following actions:

- creating a demodulated signal of voltage $U_{Dem}$ by adding minimum value of negative half cycle of the wave form of discrete processed signal of voltage $U_x$ to maximum value of positive half cycle of the wave form of discrete processed signal of voltage $U_x$ for time intervals having a signal length $T_L$ , where $T_L$ is a constant parameter, delivered by the user,

- calculating a root mean square value RMS for demodulated signal of voltage $U_{Dem}$ and comparing it with the value of another constant parameter delivered by the user as the level of root mean square value $RMS_{Lev}$ and when the value of (RMS) is smaller than the value of $RMS_{Lev}$ it indicates that there is no subsynchronous resonance, and when the value of RMS is bigger than the value of $RMS_{Lev}$ , the presence of subsynchronous resonance is identified by the determination of voltage amplitude $A_{Fss}$ of subsynchronous resonance and/or frequency $f_{Fss}$ of subsynchronous resonance.

Preferably during finding zero crossing, two hystereses for positive and negative half cycles of the wave form are established for the determination of sequences of consecutive time intervals $T_{PozI}$, $T_{NegI}$, ... $T_{PozN}$, $T_{NegN}$, respectively for positive $U_{Poz}$ and negative $U_{Neg}$ part of discrete processed signal $U_X$ between zero crossings in order to create the upper envelope $E_{up}$ and the lower envelope $E_{low}$ of discrete processed signal $U_x$ .

Preferably the absolute value of hysteresis for positive and negative half cycles of the wave form is equal to the root mean square value level $RMS_{Lev}$.

Preferably the voltage signal length $T_L$ has a time value in the time domain of minimum 0.2s.

**A computer program for detection of** subsynchronous resonance in electrical power systems with series capacitors, which computer program is loadable in and executable on a data processing unit of a computer device (8), and which computer program when being executed by the data processing unit of the computer performs the method according to claims 1-4.

The method according to the present invention is explained on the basis of an embodiment presented in the drawing , where:

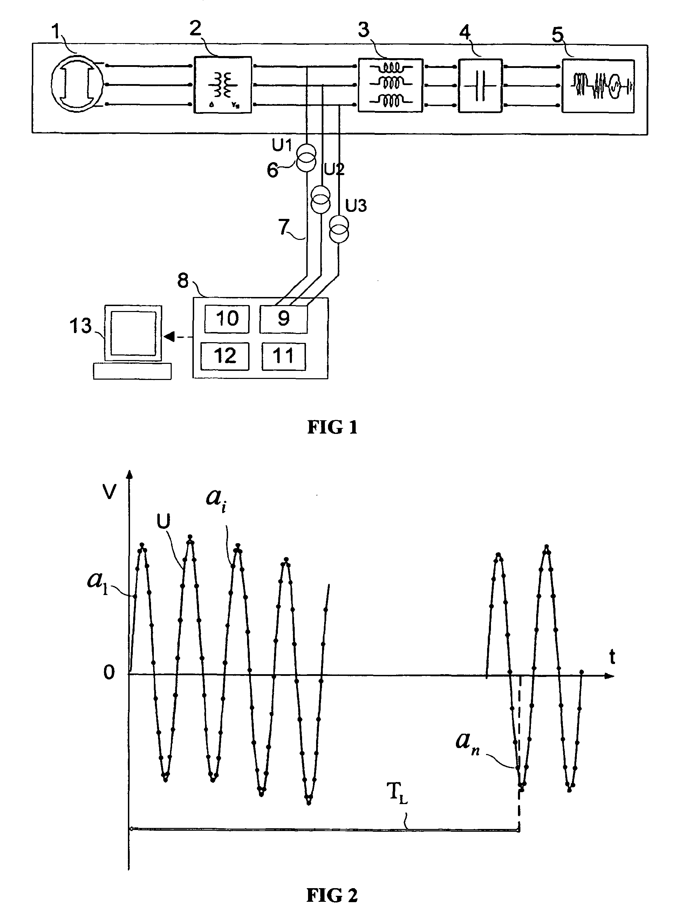

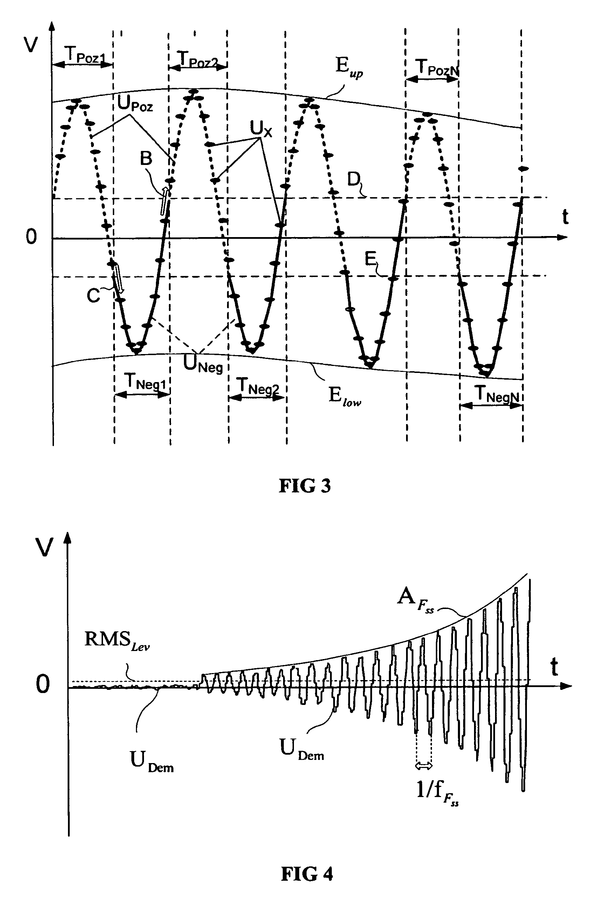

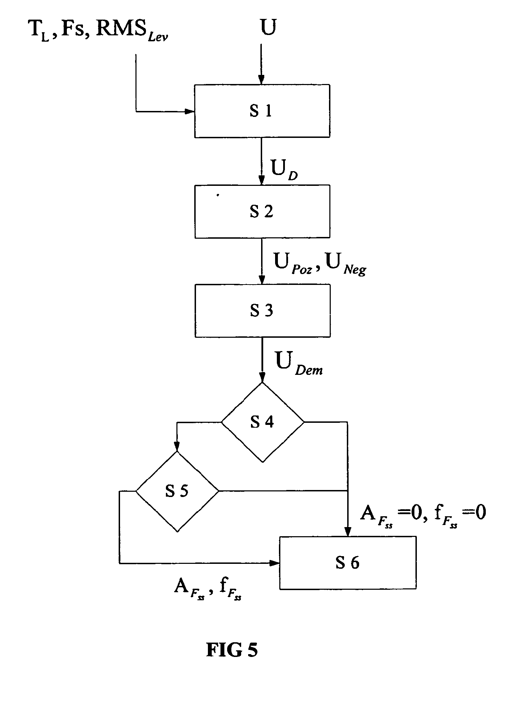

fig. 1 - shows schematically an electrical power system with series capacitors and with a generator, fig, 2 - shows a waveform of power system voltage with subsynchronous resonance frequency before a demodulation, fig. 3 - shows a waveform of discrete processed signal, fig. 4 - shows a waveform of demodulated signal with subsynchronous resonance frequency, fig. 5 - shows a flowchart of operations performed while detecting subsynchronous resonance according to the invention.

The electrical power system for the implementation of the inventive method is presented in fig. 1. The electrical power system comprises a turbine-generator 1, which forms a mechanical part of the system, and three-phase AC transmission lines connected to the turbine-generator, which together with an HV transformer 2, the impedances 3 of the lines, series capacitors 4, and end consumers 5 of the power systems form an electrical part of the power system. To each phase of the three-phase transmission lines, between the transformer 2 and the series capacitors 4, a capacitor voltage transformer CVT 6 is connected for measuring the voltage of lines U1, U2, U3. Each of the CVT transformers 6 is connected through a communication link 7 with a device for detecting and identify subsynchronous resonance phenomenon 8 in the electrical part of the power system. The device 8 is a computer with a processor unit for implementation of the method of detecting SSR and it may be a part of a protective relay or it may be a computer device installed separately to the system. The device 8 includes an analogue-digital converter 9 for converting the measured analogue signal into a digital signal, a subsynchronous resonance-detecting unit 10 for detecting SSR in transmission lines, a calculation unit 11 and a storage unit 12 for calculating and gathering data processed during the operation, and external peripheral devices 13 for visualising the results of SSR detection. The analogue-digital converter 9 for converting the measured analogue signal into a digital signal may be installed in a CVT transformer 6 instead in the device 8, which is not shown in the drawing.

The method according to the invention is realized as depicted in fig. 5 in the following steps.

Step S1

**Determination of discrete signal $U_D$ from measured online signal U.**

The voltage signal U1, U2, U3 of transmission line is measured by the CVT transformer 6 and converted into a discrete signal $U_D$ in the analogue-digital converter 9. The discrete signal $U_D$ consists of voltage value $a_i$ of i consecutive samples. For the conversion process, some constant parameters are delivered to the analogue-digital converter 9, and the conversion process is well known in the art.

The first constant parameter delivered to the analogue-digital converter 9 is the sampling frequency Fs. This parameter defines the number of samples per second taken from the analogue signal U (signal U is presented in fig. 2 as the wave form). Usually the sampling frequency is set as 1 kHz minimum, which is also a default setting for the presented invention. Settings of a lower sampling frequency may result in incorrect calculation.

The second constant parameter delivered to the analogue-digital converter 9 is the signal length $T_L$ . This parameter presented in fig. 2 defines the length of an analogue voltage signal U taken for analogue-digital conversion. To produce reliable results of future next steps the value of signal length $T_L$ should be equal to one period of the lowest subsynchronous frequency which can appear in the electrical power system. In the embodiment of the invention the value was set as minimum $T_L=0.2$ [s], which corresponds to 5 Hz of subsynchronous frequency of a transmission line. Settings of shorter signal length $T_L$ may result in incorrect calculation.

The third constant parameter delivered to the analogue-digital converter 9 is a root mean square value $RMS_{Lev}$ which defines the statistical magnitude of the discrete signal $U_D$.

The $RMS_{Lev}$ value should be equal to the amplitude of the noise level of the CVT transformer 6, which is known for each specific CVT. In future next steps this parameters allows to distinguished noise from the discrete signal $U_D$.

Step S2

**Calculation of discrete processed signal $U_x$ and determination of zero crossing points in order to calculate sequences $T_{poz1}$, $T_{Neg1}$, ... $T_{PozN}$, $T_{NegN}$, of time intervals respective for positive $U_{poz}$ and negative $U_{Neg}$ part of discrete processed signal $U_x$ between zero crossings points.**

First an arithmetic mean value $X_{mean}$ of discrete signal $U_D$ for signal length $T_L$ - fig. 2 is calculated as follows:

$$X_{mean} = \frac{a_1 + a_2 + \ldots a_i \ldots + a_n}{n} \qquad (1)$$

where $a_i$ is the voltage value of sample $i$ and $n$ is the number of all samples in the discrete signal $U_D$ The number of samples $n$ is equal to the sampling frequency Fs multiplied by signal length $T_L$.

Then discrete processed signal $U_x$ is calculated by subtracting mean value $X_{mean}$ from the voltage value $a_i$ of every sample point of the discrete signal $U_D$. If there is no subsynchronous resonance, the discrete processed signal $U_x$ maps the dominant nominal frequency of the transmission line. If there is subsynchronous occurrence, the discrete processed signal $U_x$ consists of the nominal frequency of the transmission line and subsynchronous frequency components.

$$U_X = a_i - X_{mean} \qquad (2)$$

for i =1...n .

Then the zero crossings points are identified by detecting changes in the discrete processed signal $U_x$ sign (+) or (-) - fig. 3. Always there are two types of zero crossings. One of them is when the signal value is increasing - positive zero crossing, the other when the signal value is decreasing - negative zero crossing. The positive zero crossing (arrow B) is detected when a discrete processed signal $U_x$ changes its value from minus to plus and when its value is bigger than the positive hysteresis value established as the value of the root mean square value $RMS_{Lev}$ which is known for each specific CVT 6, marked in fig. 3 as D. The negative zero crossing (arrow C) is detected when a discrete processed signal $U_x$ changes its value from plus to minus and when its value is smaller than the negative hysteresis value established as a minus value of the root mean square value $RMS_{Lev}$ which is known for each specific CVT 6, marked in fig. 3 as E. The hystereses D and E are established in order to avoid mixing zero crossing with noise which always appears in signals collected from real electrical power systems.

After finding the first zero crossing point, which can be positive or negative, the next zero crossing point, which is negative or positive respectively, is found, the time interval $T_{poz1}$ or $T_{Neg1}$ between this zero crossing points is determined as an interval for calculating the positive part $U_{poz}$ (marked in fig. 3 as dashed line) or the negative part $U_{Neg}$ (marked in fig. 3 as continuous line) relative to the discrete processed signal $U_x$. Sequences of consecutive time intervals $T_{poz1}$, $T_{Neg1,}$ ... $T_{pozN}$, $T_{NegN}$, respectively for the positive $U_{poz}$ and the negative $U_{Neg}$ part of discrete processed signal $U_x$ between zero crossings are the result of this step.

Step S3

**Calculation of a demodulated signal $U_{Dem.}$**

First for each $T_{poz1}$,... $T_{pozN}$, of time intervals respectively for positive $U_{Poz}$ from the signal length equal to the value of $T_L$, the maximum values of the discrete processed signal $U_x$ are calculated and then from the values of such maxima the upper envelope $E_{up}$ of the discrete processed signal $U_x$ is created.

Similarly for each $T_{Neg1,}$ ... , $T_{NegN}$ of time intervals respectively for negative $U_{Neg}$ from the signal length equal to the value of $T_L$, the minimum values of the discrete processed signal $U_x$ are calculated and then from the values of such minima the lower envelope $E_{low}$ of discrete processed signal $U_x$ is created.

Next the demodulated signal $U_{Dem}$ is calculated by adding the values of the lower envelop $E_{low}$ to the values of the upper envelop $E_{up}$

$$U_{Dem} = E_{up} - E_{low} \qquad (3)$$

Contrary to the discrete processed signal $U_{x}$, the demodulated signal $U_{Dem}$ does not contain the nominal frequency of the transmission line.

If the subsynchronous resonance phenomenon occurs, the discrete demodulation signal $U_{Dem}$ contains a subharmonic resonance frequency which appears as the dominant one. Before the appearance of the subsynchronous resonance phenomenon, the demodulated signal $U_{Dem}$ is smaller than the $RMS_{Lev}$ value. At the moment when the subsynchronous resonance appears, the demodulated signal $U_{Dem}$ exceeds the $RMS_{Lev}$ value.

Step S4

**Detection of the presence of subsynchronous resonance frequency in demodulated signal $U_{Dem}$**

by comparing the root mean square RMS value of the demodulated signal $U_{Dem}$ with the value of $RMS_{LeV}$

First the root mean square RMS value of the demodulated signal $U_{Dem}$ is performed. RMS value is the statistic magnitude of the discrete signal, the details of such calculation are well known to those skilled in the art.

Then the RMS value is compared to the $RMS_{Lev}$ value which was delivered as a parameter in the first step.

If the RMS value of $U_{Dem}$ is smaller than the $RMS_{Lev}$ value, that means that there is no subsynchronous resonance frequency detected in demodulated signal $U_{Dem}$ In this case an amplitude of subsynchronous resonance frequency $A_{FSS}$ and the respective frequency $f_{FSS}$ are considered equal to zero.

If the RMS value of $U_{Dem}$ signal is bigger than or equal to the $RMS_{Lev}$ value, further analysis is performed in step S5.

Step S5

**Calculation and identification of voltage amplitude $A_{FSS}$ and frequency $f_{FSS}$ , related to subsynchronous resonance**

First the calculation of FFT (Fast Fourier Transform) of $U_{Dem}$ signal is performed. The FFT operation transforms the signal from the time domain into signal in the frequency domain; the details of such calculation are well known to those skilled in the art.

Then the highest value of a voltage amplitude $A_{FSS}$ in a spectrum band between 10 % and 90 % of the nominal frequency of the transmission line is calculated and compared to the $RMS_{Lev}$ value.

If the highest value of a voltage amplitude $A_{FSS}$ is smaller then the value of $RMS_{Lev}$, that means that there is no subsynchronous resonance frequency detected *($A_{FSS}=0$, $f_{FSS}=0$)*.

If the highest value of a voltage amplitude $AF_{SS}$ is bigger than or equal to the value of $RMS_{Lev}$ then the value of amplitude $A_{FSS}$ and the respective frequency $f_{FSS}$ are considered subsynchronous resonance.

Step 6

**Visualization of subsynchronous resonance amplitude as the highest value of a voltage amplitude $A_{FSS}$ and/or the respective frequency $f_{FSS}$.**

In this step the subsynchronous resonance amplitude is displayed as the highest value of a voltage amplitude $A_{FSS}$ and/or the respective resonance frequency $f_{FSS}$ is also displayed, using well known means for displaying or printing data, connected to the computer device (8), which is not presented in the drawings.

**Claims**

1.   A method of subsynchronous resonance detection in power electrical systems with series capacitors whereby voltage signals of the power electrical systems are measured on line and whereby by finding zero crossing points of the discrete signal (40) of the measured voltage, positive and negative half cycles of the wave form of the discrete signal (40) of voltage are calculated in a computer device to which constant parameters are delivered by the user, **characterized in** comprising the following actions:

   • creating a demodulated signal ($U_{Dem}$) of voltage by adding the absolute value of the minimum value of the negative half cycle of the wave form of a discrete processed signal ($U_{X}$) of voltage to the maximum value of the positive half cycle of the wave form of the discrete processed signal ($U_{X}$) for time intervals having a signal length $T_{L}$, where $T_{L}$ is a constant parameter, delivered by the user, whereby the discrete processed signal ($U_{X}$) is calculated by subtracting a mean value ($X_{mean}$) from the voltage value ($a_i$) of every sample point of the discrete signal ($U_D$) and whereby the means value ($X_{mean}$) is the arithmetic mean value of the discrete signal ($U_D$) for the signal length $T_L$,

• calculating a root mean square value RMS for the demodulated signal of voltage ($U_{Dem}$) and comparing it with the value of another constant parameter delivered by the user as the level of root mean square value $RMS_{Lev}$ and when the value of RMS is smaller than the value of $RMS_{Lev}$ it indicates that there is no subsynchronous resonance, and when the value of RMS is bigger than the value of $RMS_{Lev}$, the presence of subsynchronous resonance is identified by the determination of the voltage amplitude ($A_{FSS}$) of a subsynchronous resonance and/or the frequency ($f_{FSS}$) of a subsynchronous resonance from the demodulated signal ($U_{Dem}$).

2. A method according to claim 1, **characterised in that** during finding zero crossing points, two hystereses for positive and negative half cycles of the wave form are established for a determination of sequences of consecutive time intervals ($T_{Poz1}$, $T_{Neg1}$, ... $T_{PozN}$, $T_{NegN}$,) respectively for the positive ($U_{Poz}$) and negative ($U_{Neg}$) part of the discrete processed signal ($U_X$) between zero crossings points in order to create the upper envelope ($E_{up}$) and the lower envelope ($E_{low}$) of discrete processed signal ($U_X$).

3. A method according to claim 2, **characterised in that** an absolute value of hysteresis for positive and negative half cycles of the wave form is equal to the root mean square value level $RMS_{Lev}$.

4. A method according to claim 1, **characterised in that** the signal length ($T_L$) has a time value in the time domain of minimum 0.2s.

5. **A computer program comprising means for detecting** of subsynchronous resonance in electrical power systems with series capacitors, which computer program is loadable in and executable on a data processing unit of a computer device (8) and which computer program when being executed by the data processing unit of the computer performs the method according to claims 1-4.

**Patentansprüche**

1. Ein Verfahren zur Detektion von subsynchroner Resonanz in Starkstromsystemen mit Reihenkondensatoren, in dem Spannungssignale der Starkstromsysteme auf der Linie und unter Anwendung des Auffindens von Nulldurchgängen des diskreten Signals ($U_0$) der gemessenen Spannung gemessen werden, die positiven und negativen Halbperioden der Wellenform des diskreten Signals ($U_0$) der Spannung in einem Computer, in den durch den Benutzer die konstanten Parameter eingegeben werden, errechnet werden, **dadurch gekennzeichnet, dass** es die folgenden Prozesse umfasst:

• Erzeugung eines demodulierten Spannungssignals ($U_{Dem}$), indem der Absolutwert des Minimalwerts der negativen Halbperiode der Wellenform eines diskreten verarbeiteten Spannungssignals ($U_X$) der zum Maximalwert der positiven Halbperiode der Wellenform des diskreten verarbeiteten Signals ($U_X$) hinzuaddiert wird, und zwar für Zeitintervalle mit einer Signallänge $T_L$, wobei $T_L$ ein konstanter Parameter ist, der vom Benutzer eingeben wird, wobei das diskrete verarbeitete Signal ($U_X$) berechnet wird, indem ein Mittelwert ($X_{mean}$) vom Spannungswert ($a_i$) jedes Sample-Punktes des diskreten Signals ($U_D$) subtrahiert wird und wobei der Mittelwert ($X_{mean}$) der arithmetische Mittelwert des diskreten Signals ($U_D$) für die Signallänge $T_L$ ist,

• Berechnung eines Wertes für den quadratischen Mittelwert RMS für das demodulierte Spannungssignal ($U_{Dem}$) und Vergleich mit dem Wert eines anderen konstanten Parameters, der vom Benutzer als Niveau des quadratischen Mittelwertes $RMS_{Lev}$ eingegeben wird, und wenn der Wert von RMS kleiner als der Wert von $RMS_{Lev}$ ist, zeigt das an, dass keine subsynchrone Resonanz vorliegt, wenn aber der Wert von RMS größer als der Wert von $RMS_{Lev}$ ist, wird das Vorliegen einer subsynchronen Resonanz durch Ermittlung der Spannungsamplitude ($A_{Fss}$) einer subsynchronen Resonanz und/oder der Frequenz ($f_{Fss}$) einer subsynchronen Resonanz des demodulierten Spannungssignals ($U_{Dem}$) festgestellt.

2. Ein Verfahren gemäß Anspruch 1, **dadurch gekennzeichnet, dass** beim Auffinden der Nulldurchgänge zwei Hysteresen für die positiven und die negativen Halbperioden der Wellenform festgelegt werden, um Sequenzen von aufeinander folgenden Zeitintervallen ($T_{Poz1}$, $T_{Neg1}$, ... $T_{PozN}$, $T_{NegN}$,) jeweils für den positiven ($U_{Poz}$) und den negativen ($U_{Neg}$) Teil des diskreten gesendeten Signals ($U_X$) zwischen den Nulldurchgängen zu bestimmen, um damit die obere Einhüllende ($E_{up}$) und die unteres Einhüllende ($E_{low}$) des diskreten gesendeten Signals ($U_X$) zu erzeugen.

3. Ein Verfahren gemäß Anspruch 2, **dadurch gekennzeichnet, dass** ein Absolutwert der Hysteresen für positive und negative Halbperioden der Wellenform gleich dem Niveau des Quadratischen Mittelwertes RMS$_{Lev}$. ist.

4. Ein Verfahren gemäß Anspruch 1, **dadurch gekennzeichnet, dass** die Länge des Spannungssignals (T$_L$) einen Zeitwert im Zeitbereich von mindestens 0.2 s hat.

5. **Ein Computerprogramm, das die Instrumente beinhaltet zur Detektion von** subsynchronen Resonanzen in Starkstromsystemen mit Reihenkondensatoren und das auf die Datenverarbeitungseinheit eines Computers (8) geladen und dort ausgeführt wird, wobei es bei der Ausführung durch die Datenverarbeitungseinheit des Computers das Verfahren gemäß den Ansprüchen 1 bis 4 anwendet.

**Revendications**

1. Procédé de détection de la résonance hyposynchrone dans les systèmes d'alimentation compensés en série, dans lequel les signaux de tension des systèmes d'alimentation sont mesurés sur la ligne et avec l'application de la détection des points zéro du signal discret (U$_0$) de la tension mesurée, sont calculées les demi-périodes positives et négatives de la forme de l'onde du signal discret (U$_0$) de la tension dans l'ordinateur auquel des paramètres constants sont fournis par l'utilisateur **caractérisée en ce qu'**il englobe les actes suivants :

   • création d'un signal de tension démodulé (U$_{Dem}$) par l'ajout de la valeur absolue minimale de la valeur de la demi-période négative de la forme de l'onde du signal discret transformé de tension (U$_X$) à la valeur maximale de la demi-période positive de la forme de l'onde du signal discret transformé de tension (U$_X$) pour les intervalles de temps d'une longueur T$_L$, où T$_L$ est un paramètre constant, fourni par l'utilisateur, et (U$_X$) est calculé en déduisant la valeur moyenne (*X$_{mean}$*) de la valeur de tension (*a$_i$*) de chaque point d'essai du signal discret (U$_D$), où (*X$_{mean}$*) est la valeur arithmétique moyenne *(X$_{mean}$)* du signal discret (U$_D$) pour la longueur du signal T$_L$,
   • calcul de la valeur moyenne carrée RMS pour le signal de tension démodulé (U$_{Dem}$) et la comparaison de celle-ci avec la valeur d'un autre paramètre constant fourni par l'utilisateur comme le niveau de la valeur moyenne carrée RMS$_{Lev}$ et quand la valeur RMS est inférieure à la valeur RMS$_{Lev}$ ceci indique que la résonance hyposynchrone n'a pas lieu, et quand la valeur RMS est supérieure à la valeur RMS$_{Lev}$, est identifiée la présence de la résonance hyposynchrone par la désignation de l'amplitude de la tension (A$_{Fss}$) de la résonance hyposynchrone et/ou de la fréquence (f$_{Fss}$) de la résonance hyposynchrone du signal de tension démodulé (U$_{Dem}$).

2. Procédé selon la revendication 1 **caractérisé en ce que** pendant la recherche du point zéro sont déterminées deux hystérésis pour les demi-périodes positives et négatives de la forme de l'onde pour déterminer les séquences des intervalles temporels successifs (T$_{Poz1}$, T$_{Neg1}$, ... T$_{PozN}$, T$_{NegN'}$) respectivement pour la partie positive (U$_{Poz}$) et négative (U$_{Neg}$) du signal discret transformé (U$_X$) entre les points zéros pour créer l'enveloppe supérieure (E$_{up}$) et l'enveloppe inférieure (E$_{low}$) du signal discret transformé (U$_X$).

3. Procédé selon la revendication 2 **caractérisé en ce que** la valeur absolue de l'hystérésis pour les demi-périodes positives et négatives de la forme de l'onde égale le niveau de la valeur moyenne carrée RMS$_{Lev}$.

4. Procédé selon la revendication 1 **caractérisé en ce que** la longueur du signal de tension (T$_L$) a une valeur temporelle dans le domaine temporel minimum 0,2s.

5. **Logiciel contenant les moyens pour détecter** la résonance hyposynchrone dans les systèmes d'alimentation compensés en série qui est chargeable et exécutable dans le dispositif de traitement de données de l'ordinateur (8) et qui pendant l'exécution par le dispositif des traitement de données de l'ordinateur réalise le procédé selon les revendications 1 à 4.

**FIG 1**

**FIG 2**

**FIG 3**

**FIG 4**

$$T_L, Fs, RMS_{Lev} \qquad\qquad U$$

```
              ┌─────────┐
              │   S 1   │
              └─────────┘
                   │ U_D
              ┌─────────┐
              │   S 2   │
              └─────────┘
                   │ U_Poz, U_Neg
              ┌─────────┐
              │   S 3   │
              └─────────┘
                   │ U_Dem
              ◇ S 4 ◇
         ◇ S 5 ◇
                        A_Fss=0, f_Fss=0
              ┌─────────┐
              │   S 6   │
              └─────────┘
         A_Fss, f_Fss
```

**FIG 5**

## REFERENCES CITED IN THE DESCRIPTION

**Patent documents cited in the description**

- US 20030160600 A
- US 4607217 A